# EUROPEAN PATENT SPECIFICATION

(11) **EP 1 244 055 B1**
(45) Date of publication and mention of the grant of the patent: **04.10.2006**
(21) Application number: 01120907.9
(22) Date of filing: 30.08.2001
(51) Int. Cl.: G06K 19/077, H01L 23/31

(54) **Method for Manufacturing a Portable Electronic Medium**
Herstellungsverfahren für ein elektronisches Medium
Méthode de fabrication pour un moyen électronique

(30) Priority: 19.03.2001 JP 2001077646
(43) Date of publication of application: 25.09.2002
(73) Proprietor: KABUSHIKI KAISHA TOSHIBA, Tokyo (JP)
(72) Inventor: Murohara, Masaru, 1-1 Shibaura 1-chome Minato-ku Tokyo (JP)
(74) Representative: Kramer - Barske - Schmidtchen

(56) References cited:
- DE-A- 19 735 171
- FR-A- 2 769 108
- US-A- 5 849 230
- PATENT ABSTRACTS OF JAPAN vol. 1996, no. 09, 30 September 1996 (1996-09-30) -& JP 08 118859 A (OKI ELECTRIC IND CO LTD), 14 May 1996 (1996-05-14)

## Description

The present invention relates to a portable electronic medium comprising a thin memory card, for instance, SD card (Secured Digital memory card), etc. and a portable electronic medium manufacturing method.

As a manufacturing method of portable semiconductor devices (for instance, IC cards, etc.) with electronic parts embedded in the card body without vacant space, there is so far available a non-contact IC card manufacturing method as disclosed in Japanese Laid Open Patent Publication No. 01-241496.

On this IC card, a module with IC, cell, etc. mounted on a circuit substrate is housed in a case. Then, a thermosetting resin is poured into the case through a hole provided on the upper case and fills the space in the case, and is then hardened by heating so that the case and the module are combined solidly.

The IC cards manufactured according to the conventional manufacturing technology described above are in a structure with the outside covered by the upper and lower cases. As a result, the thickness of this IC card became thick and it was difficult to make it thin in thickness.

French Patent Publication No. 2 769 109 describes a portable electronic medium having a terminal portion formed on a first surface and an electronic part provided on a second surface. A resin layer is laminated onto the second surface, thereby encapsulating the electronic part.

U.S. Patent No. 5,849,230 describes a portable electronic medium having an electronic part provided on a surface thereof. An ultraviolet cured resin encapsulates the electronic part and a covering material is disposed on the cured resin.

Japanese Laid-open Patent Publication No. 8-118859 describes an IC card having an IC chip mounted on a first surface thereof and terminals provided on a second surface thereof. A card base material covers the IC chip.

The present invention has been made in view of the above circumstances and it is an object to provide methods for manufacturing a portable electronic medium having a thinner thickness.

These objects are achieved by the manufacturing methods of claims 1 and 5. Additional developments of the invention are recited in the sub-claims.
FIG. 1A and FIG. 1B show the external appearance of a portable electronic medium in the embodiments of the present invention, FIG. 1A is a plan view showing the first surface of the portable electronic medium, and FIG. 1B is a plan view showing the second surface of the portable electronic medium;
FIG. 2 is a front view of the portable electronic medium shown in FIGS. 1A and 1B;
FIG. 3 is a plan view showing a substrate with electronic parts arranged on the portable electronic medium shown in FIGS. 1A and 1B;
FIG. 4 is a plan view showing a clustered substrate that is used when plural portable electronic media are simultaneously formed in another embodiment of the present invention;
FIG. 5 is a plan view further showing a clustered substrate that is used when plural portable electronic medium are simultaneously formed in another embodiment of the present invention;
FIGS. 6A-6D are sectional views showing a portable electronic medium manufacturing method in the embodiment of the present invention;
FIGS. 7A and 7B are sectional views showing a cutting process in the portable electronic medium manufacturing method in the embodiment of the present invention;
FIGS. 8A-8E are sectional views showing a portable electronic medium manufacturing method in another embodiment of the present invention;
FIGS. 9A-9D are sectional views showing a portable electronic medium manufacturing method in another embodiment of the present invention;
FIGS. 10A and 10B are sectional views showing a process for further elongating a second resin in the manufacturing method shown in FIGS. 9A-9D;
FIGS. 11A and 11B are sectional views showing the cutting process;
FIGS. 12A-12D and 13A-13C are sectional view showing the portable electronic medium in another embodiment of the present invention;
FIGS. 14A-14E are sectional views further showing the portable electronic medium manufacturing method in another embodiment of the present invention;
FIGS. 15A and 15B are sectional views showing the cutting process;
FIG. 16 is a sectional view for explaining the external appearance of the portable electronic medium in the final shape in the embodiment of the present invention;
FIG. 17 is a sectional view for explaining the external appearance of the portable electronic medium in the final shape in the embodiment of the present invention;
FIG. 18 is a sectional view for explaining the external appearance of the portable electronic medium in the final shape in the embodiment of the present invention;
FIG. 19 is a sectional view for explaining the external appearance of the portable electronic medium in the final shape in the embodiment of the present invention; and
FIGS. 20A-20C are sectional views further showing the portable electronic medium manufacturing method in another embodiment of the present invention.

Preferred embodiments of the present invention will be described below with reference to drawings.

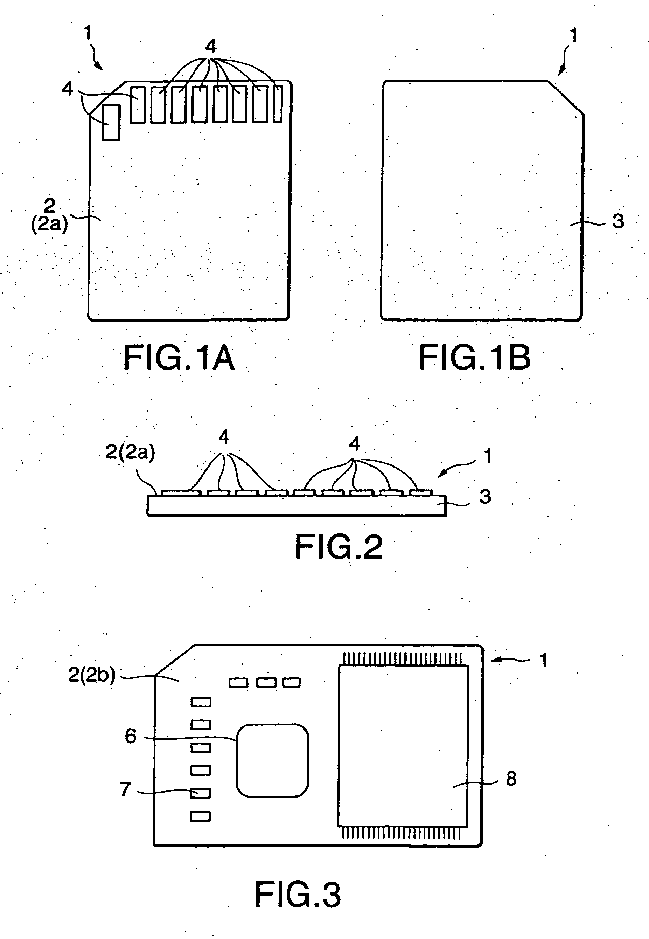

FIGS. 1A, 1B and 2 show thin type memory cards, for instance, SD cards, etc. as a portable electronic medium 1. The main body of the electronic medium 1 comprises a substrate 2 with such electronic component parts as memory, etc. mounted shown in FIG. 1A and a curing resin layer 3 shown in FIG. 1B. A first surface 2a exposed to the outside of the substrate 2 of the main body of the electronic medium 1 is formed nearly flat as electronic parts, etc. are not mounted.

Further, on the upper one end of the first surface 2a exposed to the outside of the substrate 2, plural contact pads 4 are arranged in a row as contact terminals at prescribed intervals to expose to the outside. The contact pads 4 are provided for supplying supply and exchanging data with an external device.

As shown in FIG. 3, the substrate 2 is formed by a 0.2 mm thick glass epoxy plate. On a second surface 2b that is sealed with resin, for instance, a control IC 6 for controlling the entire electrode medium 1 and a memory 8 for storing various kinds of data, a capacitor 7 and other chip parts are mounted at prescribed intervals as electronic parts.

Plural electronic parts mounted on the second surface 2b are in different heights and installed at different intervals, respectively.

Next, a manufacturing method of the electric medium 1 will be described. Further, in this embodiment, a method for manufacturing the electronic medium 1 using a clustered substrate 20 comprising the substrates 2 for 8 units of the electronic medium I will be described.

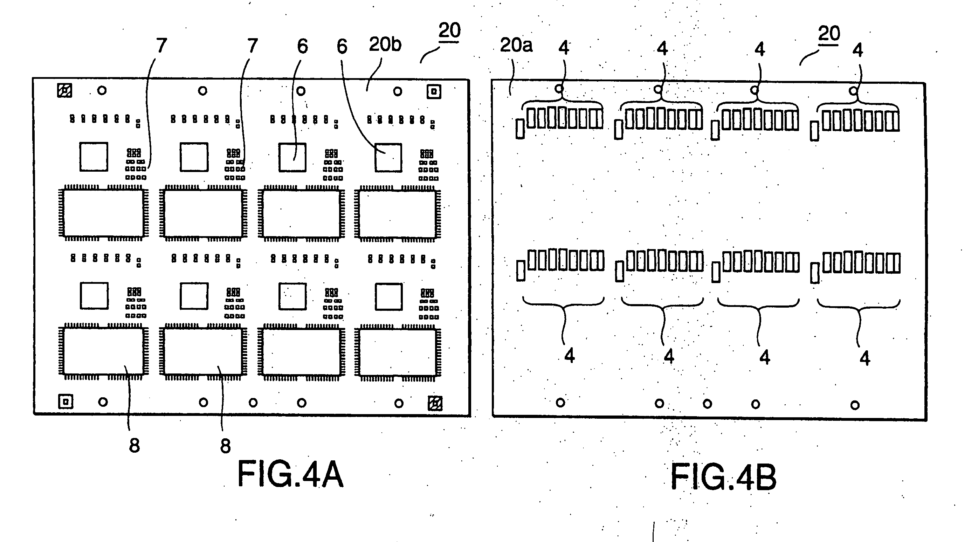

The substrate 20 shown in FIGS. 4A and 4B is a 0.2 mm thick glass epoxy plate in a size large enough for manufacturing 8 units of the electronic medium 1. The substrate 20 comprises the second surface 20b on which various kinds of electronic parts are mounted as shown in FIG. 4A and the first surface 20a with the contact pads 4 formed, exposing to the outside and serving as an armored plate as shown in FIG. 4B.

The second surface 20b has chip capacitors, chip resistors 7 and memories 8 soldered at prescribed positions and the control ICs 6 mounted by the wire bonding.

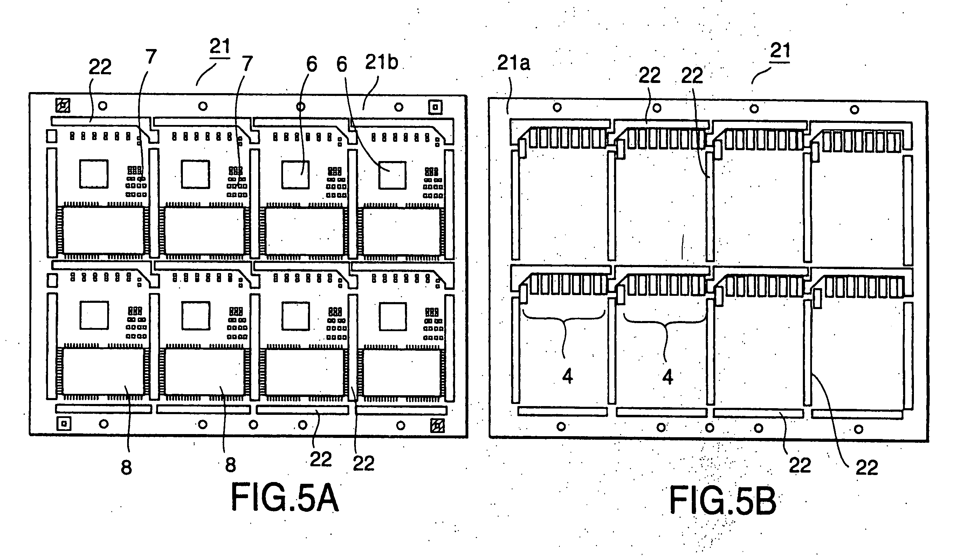

A substrate 21 shown in FIGS. 5A and 5B is different from the substrate 20 shown in FIGS. 4A and 4B in that slits 22 are formed at points equivalent to the outside of each electronic medium 1 so as to make it easy to cut it after formed. All others are formed similarly and therefore, the explanation will be omitted.

As shown in FIGS. 4A through 5B, when the control ICs 6 are connected by the wire bonding after the electronic parts are soldered on the clustered substrate 20 (or 21), the manufacturing process proceeds to the next step. As this time, the control IC 6 can be sealed by the resin sealing that is performed in the next step and therefore, the final IC chip sealing process can be omitted.

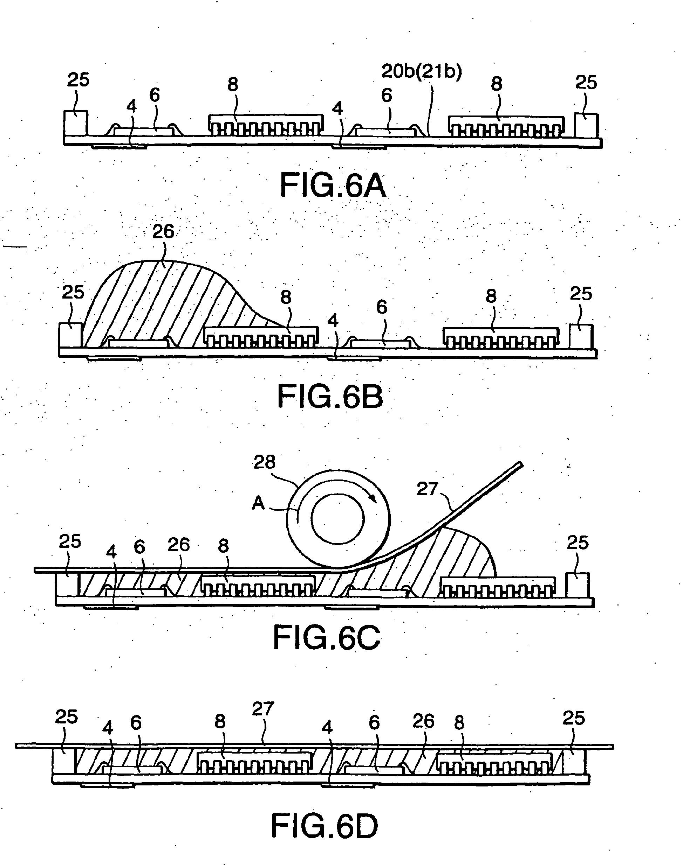

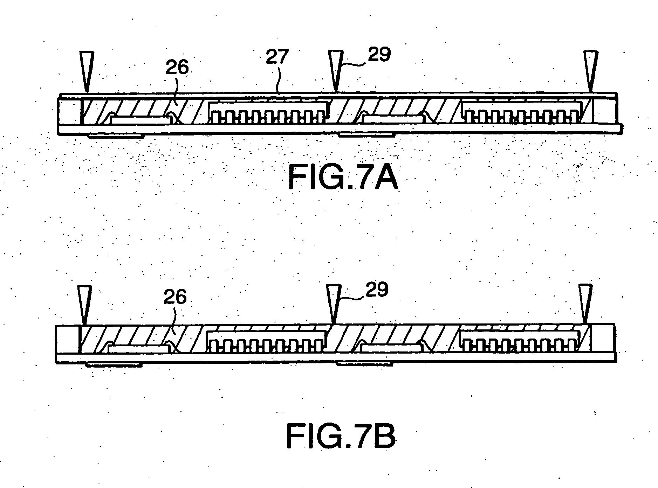

Next, using FIGS. 6A-6D and FIG. 7, an example of a manufacturing method of the electronic medium 1 for the clustered substrate 20 (or 21) with electronic parts mounted will be described.

First, as shown in FIG. 6A, a dam 25 that is formed in the rectangular shape with plastic is bonded on a surface 20b (or 21 b) of the clustered substrate 20 (or 21). The thickness of the electronic medium 1 after formed will become the height (thickness) of this dam 25 plus the thickness of the substrate. Accordingly, the dam 25 is formed in the thickness (height) of the thickness of the electronic medium 1 after formed less the thickness of the substrate.

It is considered that the dam 25 is provided only on the periphery of the clustered substrate 20 (or 21) or on the peripheral portion of individual electronic medium 1. In this example, a case to provide the dam 25 only on the periphery of the clustered substrate 20 will be described.

Then, a resin 26 is coated on the second surface 20b of the clustered substrate 20 (or 21) with the dam 25 formed as shown in FIG. 6B. Hereinafter, this resin 26 to be coated will be described using an ultraviolet curing resin in this example. However, even when a thermosetting resin is used, the same purpose and effect can be achieved.

As shown in FIG. 6C, a protective layer, for instance, a 0.1 mm thick transparent sheet 27 is laid on the second surface 20b (or 21 b) of the clustered substrate 20 (or 21) coated with the resin 26. The coated resin 26 is elongated to a flat state by rotating a roller 28 on this transparent sheet 27 in the arrow direction A.

The resin 26 thus elongated in the flat state is cured by applying ultraviolet rays as shown in FIG. 6D.

When the resin 26 is cured, the clustered substrate 20 (or 21) is cut in a prescribed shape (the shape of individual electronic medium 1) using a cutter 29, etc. as shown in FIG. 7. Thus, the electronic medium 1 is completed.

FIG. 7A shows one example to complete the electronic medium 1 in the state with the transparent sheet 27 pasted. When the electronic medium 1 is kept in the state with the sheet 27 pasted, it becomes possible to print on the sheet surface and the sheet 27 also can be used to function as a protective layer.

Instead of the above-mentioned transparent sheet 27, a printed sheet may be used. In this case, thermosetting resin is desirable as the resin 26.

FIG. 7B shows one example to complete the electronic medium 1 with the transparent sheet 27 peeled off. When the sheet 27 is peeled off, it becomes possible to form the electronic medium 1 more thin.

On the first surface of the substrate of the electronic medium 1 manufactured according to the method shown in the above embodiment, plural contact terminals are arranged nearly in a row and plated to form one outer surface of the electronic medium 1 as shown in FIGS. 7A and 7B.

On the second surface with electronic parts mounted, a laminated resin layer is formed nearly in the same size as the substrate. This resin layer is preferably formed so as to fill the spaces between electronic parts mounted on the second surface and forms another outer surface of the electronic medium 1.

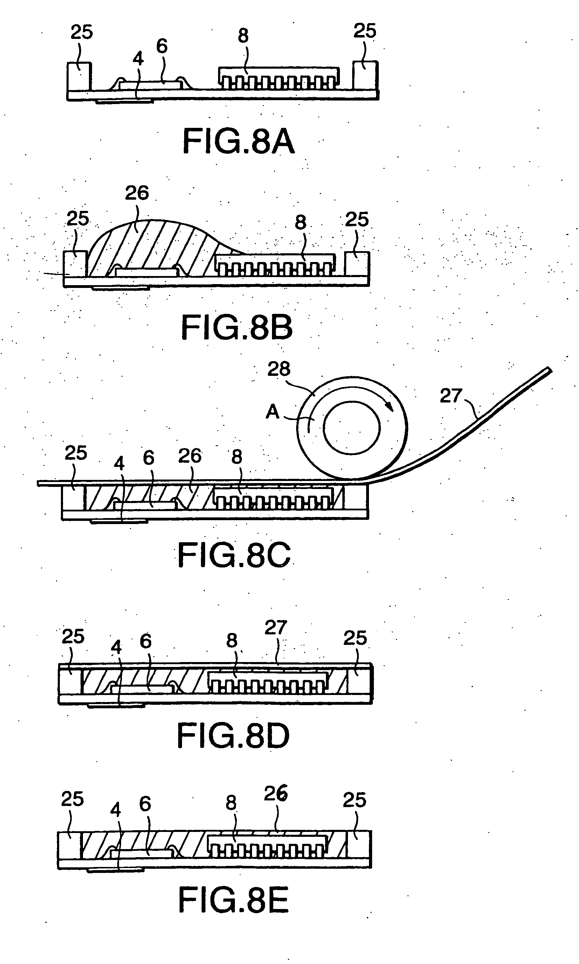

Further, FIGS. 8A-8E show a modified example of the embodiment explained referring to FIGS. 6A-6D. The embodiments explained referring to FIGS. 6A-6D were explained according to the method for simultaneously manufacturing plural electronic media 1 using a clustered substrate. However, not restricted to this embodiment, when manufacturing a single electronic medium, this method has the same merit and is effective as in the example shown in FIGS. 8A-8E.

FIGS. 8A-8E differ from FIGS. 6A-6D in that a single electronic media is manufactured and the same portions are assigned with the same reference numerals shown in FIGS. 6A-6D. Further, the finally completed electronic medium may be in the state with a sheet shown in FIG. 8D. In addition, it may be in the state with the sheet peeled off as shown in FIG. 8E. Furthermore, it may be considered to cut the dam 25 to a prescribed size at the periphery of a substrate.

Next, an embodiment of the manufacturing method of the electronic medium 1 for the clustered substrate 20 (or 21) will be described referring to FIGS. 9A-11B.

First, a dam 25 is bonded on the second surface 20b (or 21 b) of the clustered substrate 20 (or 21) as shown in FIG. 9A. The thickness of the electronic medium 1 after formed depends on the height (thickness) of this dam and the thickness of the substrate. Accordingly, the dam 25 is formed in a thickness (height) by reducing the thickness of the substrate from the thickness of the electronic medium 1 after formed.

It is considered that the dam 25 is provided on the periphery only of the clustered substrate 20 (or 21) or on the peripheral portion only of the individual electronic medium 1. In this embodiment, a case wherein the dam 25 is provided on the periphery only of the clustered substrate 20 (or 21) will be described.

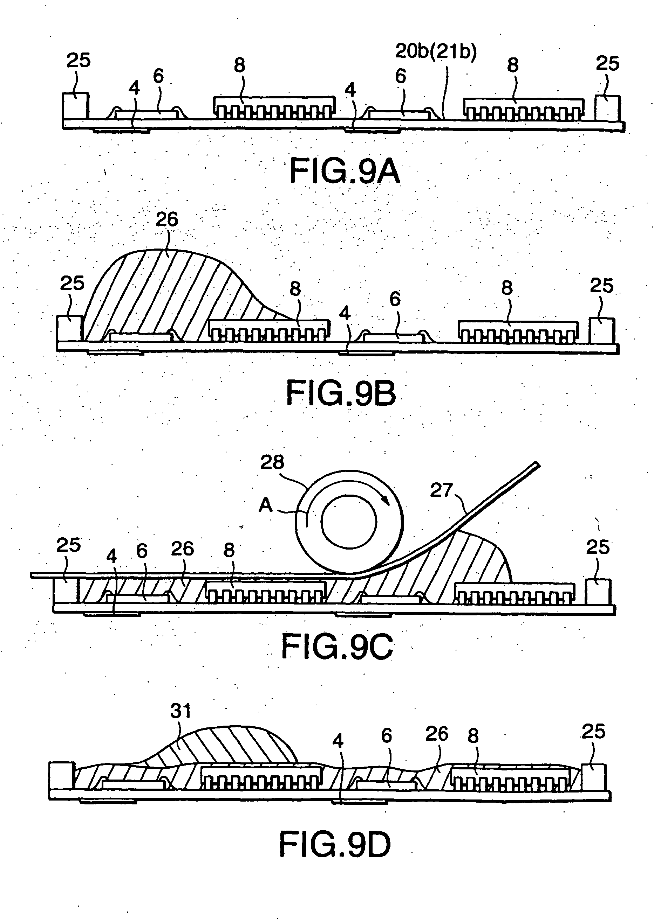

The resin 26 is coated on the second surface 20b (or 21) of the clustered substrate 20 (or 21b) on which the dam 25 is formed as shown in FIG. 9B. Hereinafter, in this embodiment, this resin 26 to be coated will be explained using an ultraviolet setting resin. However, the same purpose and effect can be achieved even when a thermosetting resin is used.

Lay a first sheet 27 on the second surface 20b (or 21b) of the clustered substrate 20 (or 21) with the resin 26 coated as shown in FIG. 9C. Elongate the resin 26 by rotating a roller 28 in the arrow direction A on the first sheet 27. Thus, the coated resin 26 is flattened.

Cure the resin 26 by applying ultraviolet rays on the resin 26 prepared in the flat state. At this time, if the surface of the cured resin becomes uneven because of the contraction when curing the resin as shown in FIG. 9D, peel off the first sheet 27 and coat a resin 31 (hereinafter, referred to as a second resin) again over the resin surface.

At this time, in this embodiment, a resin that has a slightly softer characteristic than the hardness of the formerly coated/cured resin (the first resin) is used for the second resin 31.

Lay a second sheet 32 on the coated second resin 31 as shown in FIG. 10A. Elongate the second resin 31 by rotating the roller 28 on the second sheet 32 in the arrow direction A. Thus, the coated second resin 31 is flattening.

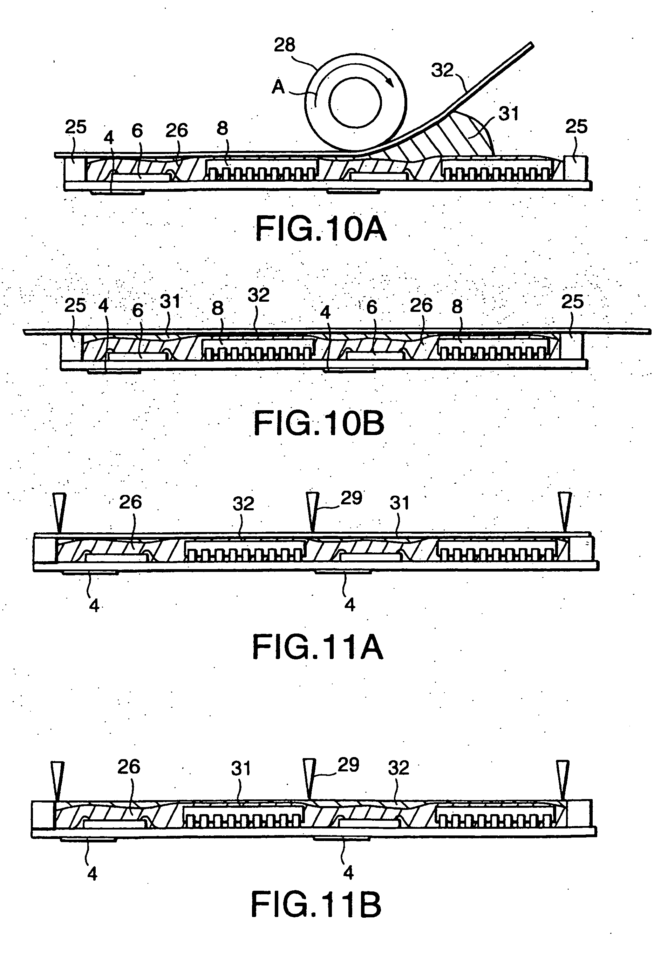

Cure the second resin 31 by applying ultraviolet rays to the second resin thus prepared in the flat state as shown in FIG. 10B.

When the second resin 31 is thus cured, complete the electronic medium 1 by cutting the clustered substrate 20 (or 21) in the prescribed shape (the shape of individual electronic medium) using the cutter 29, etc.

As shown in FIGS. 11A and 11B, the electronic medium 1 manufactured according to the method shown in the above embodiment has the first surface of the substrate plated to arrange that plural contact pads 4 nearly in a row and formed one outer surface of the electronic medium 1.

Further, a first resin layer is formed in the nearly same size as the substrate and laminated on the second surface with electronic parts mounted. This first resin layer preferably fills the clearances between electronic parts mounted on the second surface.

The surface of the first resin layer will become uneven because of different heights of covering electronic parts thereon when the resin is cured and contracted. A second resin layer is laminated on the first resin layer so as to bury the uneven surface of the first resin layer and forms the other outer surface of the electronic medium 1.

Further, FIG. 11A shows one embodiment to complete the electronic medium 1 in the state with a second sheet 32 pasted. When the second sheet 32 is kept in the pasted state, it becomes possible to apply printing, etc. on the surface of this sheet of the electronic medium 1 and the sheet also functions as a protective layer.

Further, FIG. 11B shows one embodiment to complete the electronic medium 1 with the second sheet 32 peeled off. When the second sheet 32 is peeled off, it becomes possible to form the electronic medium 1 in more thin thickness.

Thus, by coating/filling resin in several times, it becomes possible to make the surface flat even when a rate of shrinkage is different, resulting from a difference in heights of mounted electronic parts. Accordingly, there is also such an effect that the surface can be formed so as to have a uniform strength.

Further, when resin is coated/cured in several times, a new effect can be obtained by changing material (hardness), curing method (heat, ultraviolet rays, etc.), color (transparent, colored such as black, etc.

For instance, when a resin is coated/cured in several times, the lastly coated resin becomes the outer armor of the electronic medium 1. Accordingly, when a relatively hard resin is used for preceding coating/curing (the first resin) and a resin softer than the preceding resin for the last coating (the second resin), it is possible to make a structure capable of absorbing a shock from the outside while keeping its strength.

Further, when an ultraviolet curing resin is used, a transparent sheet is used but when using a thermosetting resin, a sheet color is not specified. Accordingly, when a transparent resin is used for the preceding coating/curing (the first resin) and a same colored resin as the substrate (e.g., black) for the last coating (the second resin), an electronic medium can be manufactured at a cheap cost.

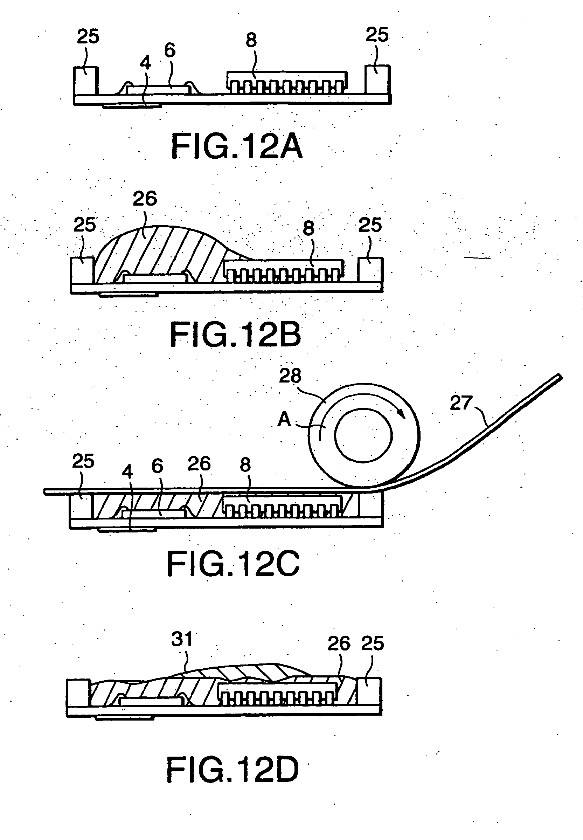

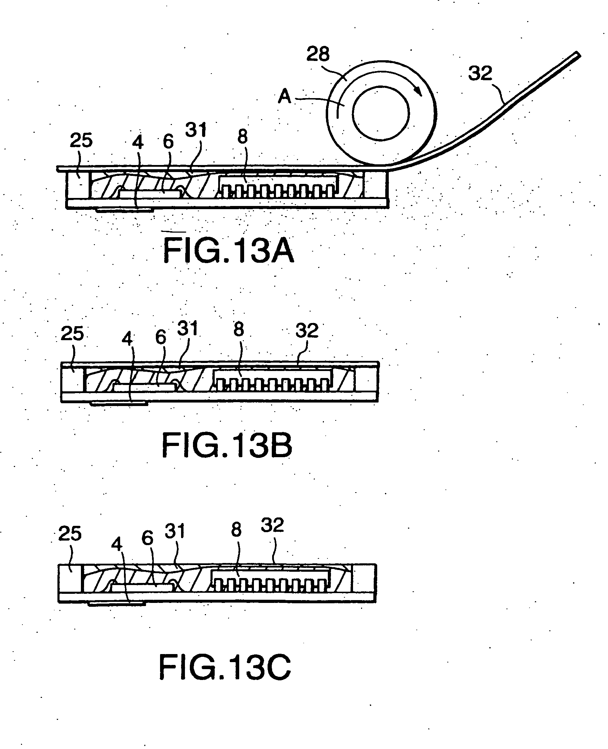

Further, FIGS. 13A-13C show a modified embodiment of what is explained referring to FIGS. 12A-12D. In the embodiment explained referring to FIGS. 10A-11B, the simultaneous manufacturing method of plural electronic media 1 using a clustered substrate was explained. However, not restricted to this, the method has the same merit and is effective as in the modified examples shown in FIGS. 12A-13C.

Further, what are shown in FIGS. 12A-13C differ from those shown in FIGS. 9A-11B in that only a single electronic medium is manufactured and the same reference numerals as those shown in FIGS. 9A-11B are used for the same parts. Further, the finally completed electronic medium may be in the state with the sheet pasted as shown in FIG. 13B or with the sheet peeled off as shown in FIG. 13C. Furthermore, it is also considered that the dam 25 is cut to a prescribed size at the periphery of the substrate.

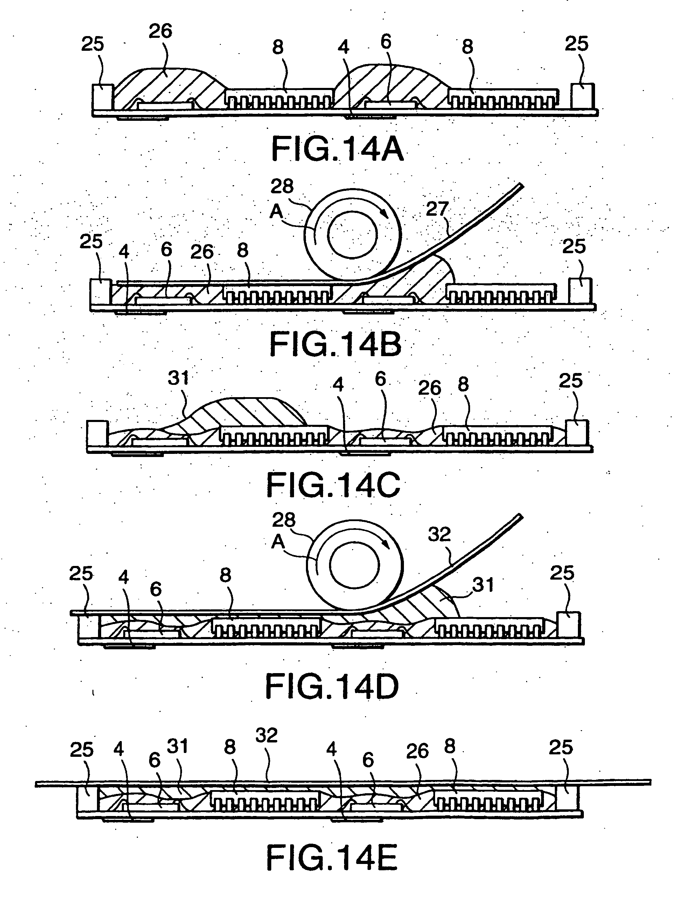

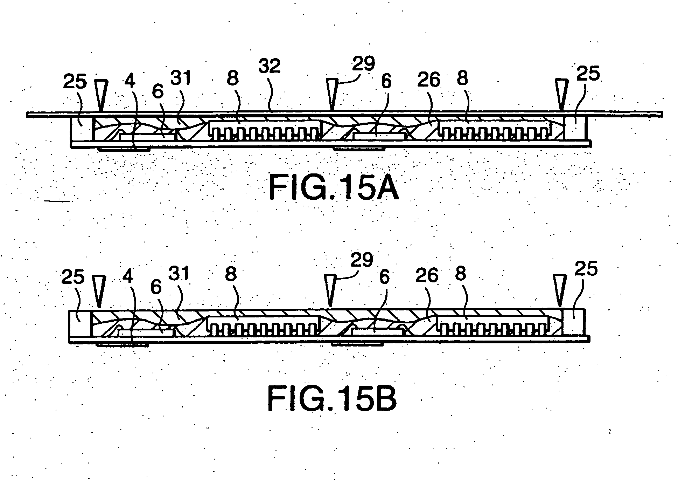

Further, FIGS. 14A-15B show modified examples of the embodiments of the electronic medium explained referring to FIGS. 9A-11B. In the examples explained referring to FIGS. 9A-11B, the first resin 26 is coated on the overall surface of the second surface 20b (or 21).

On the contrary, in the modified examples shown in FIGS. 14A-15B, the second resin 31 is coated on the portion on which the electronic parts are not mounted and on the electronic parts of low mounting height on the second surface 20b (or 21 b).

Accordingly, when the second resin 31 is coated/cured after forming the second surface 20b (or 21b) almost flat with electronic parts in high mounting height and the first resin 26, a rate of shrinkage when the second resin 31 is cured becomes uniform. Accordingly, the surface of the second resin 31 formed on the outer surface exposed to the outside is formed flat without uneven portions.

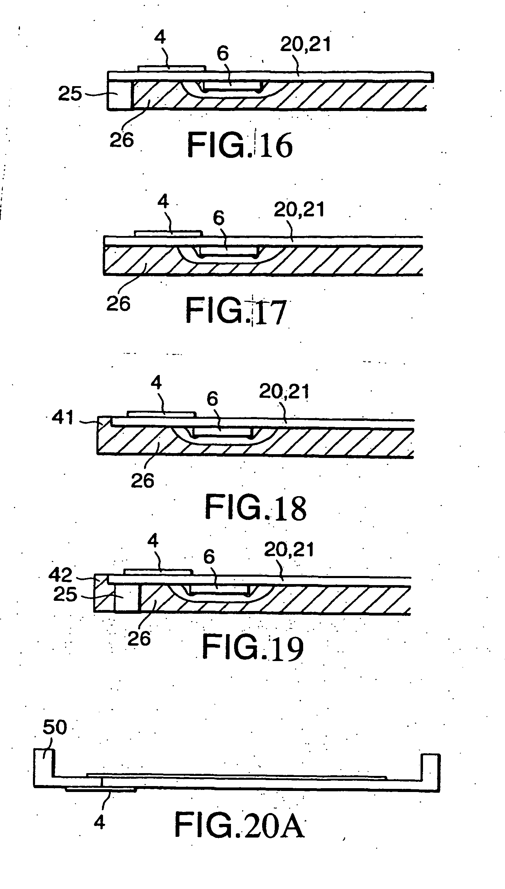

As shown in all the embodiments and modified examples shown above, the external appearance and the sectional view of the final shape of the electronic medium 1 of this invention will be explained referring to FIGS. 16-19.

FIG. 16 shows the dam that is to dam up a coating/hardening resin at a prescribed position and is used as a frame of the electronic medium as it is. FIG. 17 shows the dam that is separated when the clustered substrate is cut into individual electronic media after the resin is hardened. Shown in FIG. 18 is a case using a substrate with slits formed as shown in FIG. 5, wherein the periphery of the electronic medium and the ends of the contact pads are not the substrate but are formed with a resin. FIG. 19 shows a case using a substrate with the slits formed as shown in FIG. 5 wherein a dam is formed, coated with a resin and hardened. The periphery is formed with a resin not a substrate like the case shown in FIG. 18. However, as the dam 25 is formed in the inside, the strength is increased more than the structure shown in FIG. 18.

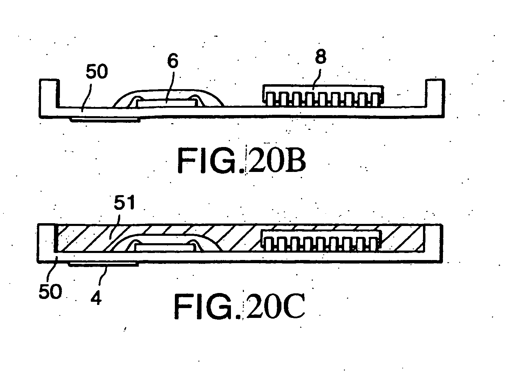

Next, the method for manufacturing a single electronic medium individually will be explained referring to FIG. 20. As shown in FIG. 20A, in this embodiment a resin made case 50 formed with a resin without using a substrate is pre-wired for connecting electronic parts.

Then, as shown in FIG. 20B, after mounting various kinds of electronic parts on the resin made case 50, the inside of the resin made case 50 is coated with a resin 51. Hereinafter, an ultraviolet curing resin is used for this resin 51 in this embodiment. However, when a thermosetting resin is used, the same purpose and merit are achieved.

Then, the surface of the coated resin 51 is flattened using a transparent sheet and a roller.

The resin 51 that is processed to be flat is applied with ultraviolet rays to harden it as shown in FIG. 20C. When the resin 51 is hardened, the electronic medium 1 is completed.

In this embodiment, when a wired resin made case is used instead of a substrate, there are such merits that the entire electronic media can be manufactured similarly and the strengths and characteristics of the entire electronic media can be made uniform.

As described above, according to the present invention, it is possible to provide thinner portable electronic media.

## Claims

1. A manufacturing method of a portable electronic medium (1) comprising a circuit substrate (2; 20; 21) having a first surface (2a; 20a) exposed to the outside, thereby forming a first outer surface, and a second surface (2b; 20b) provided on the back of the first surface (2a; 20a) and having one or more electronic parts (6, 7, 8) mounted thereon, wherein a terminal portion (4) is formed on the first surface of the circuit substrate (2; 20; 21) for exchanging data with an external device, the method comprising:
supplying a resin (26) to cover the electronic part(s) (6, 7, 8) and the entire second surface (2b; 20b), and
laying a sheet (27) on the resin (26),
**characterized by**:
elongating the resin (26) to a flat state by rotating a roller (28) on the sheet (27) and
hardening the resin (26).

2. A portable electronic medium manufacturing method according to claim 1, further comprising removing the sheet (27) after the resin (26) has hardened during the hardening step.

3. A portable electronic medium manufacturing method according to claim 1 or 2, further comprising printing information on the surface of the sheet (27) exposed to the outside after the resin (26) has hardened during the hardening step.

4. A portable electronic medium manufacturing method according to any one of claims 1-3, wherein the sheet (27) is transparent, the resin (26) is an ultraviolet curing resin, and the hardening step comprises applying ultraviolet rays to the resin (26) through the transparent sheet (27).

5. A manufacturing method of a portable electronic medium (1) comprising a circuit substrate (2; 20; 21) having a first surface (2a; 20a) exposed to the outside, thereby forming a first outer surface, and a second surface (2b; 20b) provided on the back of the first surface and having one or more electronic parts (6, 7, 8) mounted thereon, wherein a terminal portion (4) is formed on the first surface (2a; 20a) of the circuit substrate (2; 20; 21) for exchanging data with an external device, the method comprising:
supplying a first resin (26) to all portions of the second surface (2b; 20b) other than portion(s) having the electronic part(s) (6, 7, 8) mounted thereon, and
laying a first sheet (27) on the first resin (26),
**characterized by**:
elongating the first resin (26) to a flat state by rotating a roller (28) on the first sheet (27),
hardening the first resin (26) supplied in the first supplying step,
supplying a second resin (31) to the entire surface of the first resin (26) hardened during the first hardening step;
laying a second sheet (32) on the second resin (31),
elongating the second resin (31) to a flat state by rotating the roller (28) on the second sheet (32), and
hardening the second resin (31).

6. A portable electronic medium manufacturing method according to claim 5, wherein the hardened second resin (31) has a hardness differing from the hardened first resin (26).

7. A portable electronic medium manufacturing method according to claim 6, wherein the hardened second resin (31) is softer than the hardened first resin (26).

8. A portable electronic medium manufacturing method according to claim 5, 6 or 7, wherein the second resin (31) has a color differing from the color of the first resin (26).

9. A portable electronic medium manufacturing method according to any one of claims 5-8, wherein the first and second sheets (27, 32) are transparent, the first and second resins (26, 31) are ultraviolet curing resins, the first resin (26) is hardened by applying ultraviolet rays to the first resin (26) through the first transparent sheet (27) and the second resin (32) is hardened by applying ultraviolet rays to the second resin (31) through the second transparent sheet (32).

10. A portable electronic medium manufacturing method according to any one of claims 1-9, further comprising cutting the hardened resin to a size of the final shape.

11. A portable electronic medium manufacturing method according to claim 10, wherein the hardened resin is cut after each of the first and the second hardening steps to the size of final shape.

## Patentansprüche

1. Herstellungsverfahren eines tragbaren elektronischen Mediums (1), das ein Schaltungssubstrat (2; 20; 21) enthält, das eine erste Oberfläche (2a; 20a), die nach außen freigelegt ist, wodurch eine erste äußere Oberfläche gebildet wird, und eine zweite Oberfläche (2b; 20b) aufweist, die auf der Rückseite der ersten Oberfläche (2a; 20a) bereitgestellt ist und ein oder mehrere elektronische Teile (6, 7, 8), die darauf montiert sind, enthält, wobei ein Anschlussbereich (4) auf der ersten Oberfläche des Schaltungssubstrat (2; 20; 21) gebildet ist zum Austauschen von Daten mit einer externen Vorrichtung, wobei das Verfahren aufweist:
Liefern eines Harzes (26) zum Abdecken des/der elektronischen Teils/Teile (6, 7, 8) und der gesamten zweiten Oberfläche (2b; 20b) zu bedecken, und
Legen eines Blattes (27) auf das Harz (26),
**gekennzeichnet durch**:
Ausdehnen des Harzes (26) in einen flachen Zustand **durch** Drehung einer Rolle (28) auf dem Blatt (27) und Aushärten des Harzes (26).

2. Herstellungsverfahren für ein tragbares elektronisches Medium nach Anspruch 1, ferner mit einem Entfernen des Blattes (27) nachdem das Harz (26) während des Aushärtungsschrittes ausgehärtet ist.

3. Herstellungsverfahren für ein tragbares elektronisches Medium nach Anspruch 1 oder 2, ferner mit einem Drucken von Information auf die Oberfläche des Blattes (27), die nach außen freigelegt ist, nachdem das Harz (26) während des Aushärtungsschrittes ausgehärtet ist.

4. Herstellungsverfahren für ein tragbares elektronisches Medium nach einem der Ansprüche 1 bis 3, wobei das Blatt (27) transparent ist, das Harz (26) ein ultraviolettes Aushärtungsharz ist, und der Aushärtungsschritt das Anwenden von ultravioletten Strahlen auf das Harz (26) durch das transparente Blatt (27) hindurch aufweist.

5. Herstellungsverfahren eines tragbaren elektronischen Mediums (1), das ein Schaltungssubstrat (2; 20; 21) enthält, das eine erste Oberfläche (2a; 20a), die nach außen freigelegt ist, wodurch eine erste äußere Oberfläche gebildet ist, und eine zweite Oberfläche (2b; 20b) aufweist, die auf der Rückseite der ersten Oberfläche bereit gestellt ist und ein oder mehrere elektronische Teile (6, 7, 8), die darauf montiert sind, aufweist, wobei ein Anschlussbereich (4) auf der ersten Oberfläche (2a; 20a) des Schaltungssubstrats (2; 20; 21) gebildet ist zum Austauschen von Daten mit einer externen Vorrichtung,
wobei das Verfahren aufweist:
Liefern eines ersten Harzes (26) an alle Bereiche der zweiten Oberfläche (2b; 20b), die andere sind als ein Bereich oder Bereiche, der/die das (die) elektronische(n) Teil(e) (6, 7, 8), das/die darauf montiert ist/sind, aufweist/aufweisen, und
Legen eines ersten Blattes (27) auf das erste Harz (26), **gekennzeichnet durch**
Ausdehnen des ersten Harzes (26) in einen flachen Zustand **durch** Drehung einer Rolle (28) auf dem ersten Blatt (27),
Aushärten des ersten Harzes (26), das in dem ersten Lieferschritt geliefert worden ist,
Liefern eines zweiten Harzes (31) zu der gesamten Oberfläche des ersten Harzes (26), das während des ersten Aushärtungsschrittes ausgehärtet,
Legen eines zweiten Blattes (32) auf das zweite Harz (31),
Ausdehnen des zweiten Harzes (31) in einen flachen Zustand **durch** Drehung der Rolle (28) auf dem zweiten Blatt (32), und
Aushärten des zweiten Harzes (31).

6. Herstellungsverfahren eines tragbaren elektronischen Mediums nach Anspruch 5, wobei das ausgehärtete zweite Harz (31) eine Härte aufweist, die sich von der des ausgehärteten ersten Harzes (26) unterscheidet.

7. Herstellungsverfahren eines tragbaren elektronischen Mediums nach Anspruch 6, wobei das ausgehärtete zweite Harz (31) weicher als das ausgehärtete erste Harz (26) ist.

8. Herstellungsverfahren eines tragbaren elektronischen Mediums nach Anspruch 5, 6 oder 7, wobei das zweite Harz (31) eine Farbe hat, die von der Farbe des ersten Harzes (26) verschieden ist.

9. Herstellungsverfahren eines tragbaren elektronischen Mediums nach einem der Ansprüche 5 bis 8, wobei das erste und das zweite Blatt (27, 32) transparent sind, das erste und das zweite Harz (26, 31) ultraviolette Aushärtungsharze sind, das erste Harz (26) ausgehärtet wird, indem ultraviolette Strahlen an das erste Harz (26) durch das erste transparente Blatte (27) hindurch geliefert werden, und das zweite Harz (32) ausgehärtet wird, indem ultraviolette Strahlen an das zweite Harz (31) durch das zweite transparente Blatte (32) hindurch geliefert werden.

10. Herstellungsverfahren eines tragbaren elektronischen Mediums nach einem der Ansprüche 1 bis 9, ferner mit einem Schneiden des ausgehärteten Harzes in eine Größe der Endform.

11. Herstellungsverfahren eines tragbaren elektronischen Mediums nach Anspruch 10, wobei das ausgehärtete Harz nach dem ersten und zweiten Aushärtungsschritt jeweils in die Größe der Endform geschnitten wird.

## Revendications

1. Procédé de fabrication d'un moyen électronique portatif (1) comprenant un substrat de circuit (2, 20, 21) ayant une première surface (2a, 20a) exposée vers l'extérieur, formant de cette façon une première surface extérieure, et une seconde surface (2b, 20b) prévue sur l'arrière de la première surface (2a, 20a) et ayant une ou plusieurs pièces électroniques (6, 7, 8) montées sur celle-ci, dans lequel une partie terminale (4) est formée sur la première surface du substrat de circuit (2, 20, 21) pour échanger des données avec un dispositif externe, ledit procédé comprenant :
l'apport d'une résine (26) pour recouvrir la ou les pièces électroniques (6, 7, 8) et la totalité de la seconde surface (2b, 20b), et
le dépôt d'une feuille (27) sur la résine (26),
**caractérisé par** :
l'élongation de la résine (26) jusqu'à un état plat par rotation d'un rouleau (28) sur la feuille (27) et
le durcissement de la résine (26).

2. Procédé de fabrication d'un moyen électronique portatif selon la revendication 1, comprenant en outre le retrait de la feuille (27) après que la résine (26) a durci pendant l'étape de durcissement.

3. Procédé de fabrication d'un moyen électronique portatif selon la revendication 1 ou 2, comprenant en outre l'impression d'information sur la surface de la feuille (27) exposée vers l'extérieur, après que la résine (26) a durci pendant l'étape de durcissement.

4. Procédé de fabrication d'un moyen électronique portatif selon l'une quelconque des revendications 1 à 3, dans lequel la feuille (27) est transparente, la résine (26) est une résine à séchage ultraviolet, et l'étape de durcissement comprend l'application de rayonnements ultraviolets sur la résine (26) à travers la feuille transparente (27).

5. Procédé de fabrication d'un moyen électronique portatif (1) comprenant un substrat de circuit (2, 20, 21) ayant une première surface (2a, 20a) exposée vers l'extérieur, formant de cette façon une première surface extérieure, et une seconde surface (2b, 20b) prévue sur l'arrière de la première surface et ayant une ou plusieurs pièces électroniques (6, 7, 8) montées sur celle-ci, dans lequel une partie terminale (4) est formée sur la première surface (2a, 20a) du substrat de circuit (2, 20, 21) pour échanger des données avec un dispositif externe, ledit procédé comprenant":
l'apport d'une première résine (26) à toutes les parties de la seconde surface (2b, 20b), autres que les parties ayant la(les) pièce(s) électronique(s) (6, 7, 8) montées sur celles-ci, et
le dépôt d'une première feuille (27) sur la première résine (26),
**caractérisé par** :
l'élongation de la première résine (26) jusqu'à un état plat par rotation d'un rouleau (28) sur la première feuille (27),
le durcissement de la première résine (26) fournie pendant la première étape d'apport,
l'apport d'une seconde résine (31) à la totalité de la surface de la première résine (26) durcie pendant la première étape de durcissement,
le dépôt d'une seconde feuille (32) sur la seconde résine (31),
l'élongation de la seconde résine (31) jusqu'à un état plat par rotation du rouleau (28) sur la seconde feuille (32), et
le durcissement de la seconde résine (31).

6. Procédé de fabrication d'un moyen électronique portatif selon la revendication 5, dans lequel la seconde résine durcie (31) a une dureté différente de la première résine durcie (26).

7. Procédé de fabrication d'un moyen électronique portatif selon la revendication 6, dans lequel la seconde résine durcie (31) est plus molle que la première résine durcie (26).

8. Procédé de fabrication d'un moyen électronique portatif selon la revendication 5, 6 ou 7, dans lequel la seconde résine (31) a une couleur différente de la couleur de la première résine (26).

9. Procédé de fabrication d'un moyen électronique portatif selon l'une quelconque des revendications 5 à 8, dans lequel la première et la seconde feuille (27, 32) sont transparentes, la première et la seconde résine (26, 31) sont des résines à séchage ultraviolet, la première résine (26) est durcie par application de rayonnements ultraviolets sur la première résine (26), à travers la première feuille transparente (27) et la seconde résine (32) est durcie par application de rayonnements ultraviolets sur la seconde résine (31), à travers la seconde feuille transparente (32).

10. Procédé de fabrication d'un moyen électronique portatif selon l'une quelconque des revendications 1 à 9, comprenant en outre la découpe de la résine durcie pour donner les dimensions de la forme finale.

11. Procédé de fabrication d'un moyen électronique portatif selon la revendication 10, dans lequel la résine durcie est découpée après chacune parmi la première et la seconde étape de durcissement, pour donner les dimensions de la forme finale.
